# EUROPEAN PATENT APPLICATION

(11) **EP 2 388 816 A1**
(43) Date of publication of application: **23.11.2011**
(21) Application number: 09840312.4
(22) Date of filing: 18.12.2009
(51) Int. Cl.: H01L 25/065, G01L 9/00, H01L 25/07, H01L 25/16, H01L 25/18, H01L 29/84

(54) **SEMICONDUCTOR SENSOR DEVICE, METHOD OF MANUFACTURING SEMICONDUCTOR SENSOR DEVICE, PACKAGE, METHOD OF MANUFACTURING PACKAGE, MODULE, METHOD OF MANUFACTURING MODULE, AND ELECTRONIC DEVICE**

(30) Priority: 23.02.2009 JP 2009039571
(71) Applicant: Fujikura, Ltd., Tokyo 135-8512 (JP)
(72) Inventor: YAMAMOTO, Satoshi, Sakura-shi Chiba 285-8550 (JP)
(74) Representative: Cabinet Plasseraud
(86) International application number: PCT/JP2009/007036
(87) International publication number: WO 2010/095205

(57) **Abstract**

A semiconductor sensor device is provided which is composed of: a semiconductor sensor chip that includes a first substrate (21), a sensor circuit (23B) formed on the first substrate (21), a first conductive portion (23C) electrically connected to the sensor circuit (23B), and a first redistribution layer (25) electrically connected to the first conductive portion (23C); a semiconductor chip that includes a second substrate (31), a processing circuit, formed on the second substrate (31), that processes an electrical signal output from the sensor circuit (23B), a second conductive portion (33) electrically connected to the processing circuit, and a second redistribution layer (35) electrically connected to the second conductive portion (33); and a conductive connection component that electrically connects the first redistribution layer (25) and the second redistribution layer (35), wherein at least one of the thickness of the first redistribution layer (25) and the thickness of the second redistribution layer (35) is 8 to 20 µm.

## Description

### TECHNICAL FIELD

The present invention relates to a semiconductor sensor device which includes at least a semiconductor sensor chip such as a pressure sensor or an acceleration sensor and a semiconductor chip for processing signals thereof, and in which the semiconductor sensor chip and the semiconductor chip are electrically connected to each other through a conductive connection component, and a method of manufacturing the semiconductor sensor device.

Specifically, the invention relates to a semiconductor sensor device having a structure which is capable of separating a semiconductor chip and a semiconductor sensor chip from each other after the semiconductor chip and the semiconductor sensor chip are connected to each other by a connection component, and replacing a defective chip by a non-defective chip, and a method of manufacturing the semiconductor sensor device which is capable of achieving an improvement in the yield in a mounting step, reducing manufacturing costs, and reducing the environmental load.

In addition, the invention relates to a package in which the above-mentioned semiconductor sensor device is mounted, a method of manufacturing the package, a module, a method of manufacturing the module, and an electronic device.

This application claims priority based on Japanese Patent Application No. 2009-039571 filed in the Japanese Patent Office on February 23, 2009, the contents of which are incorporated herein by reference.

### BACKGROUND ART

In recent years, MEMS (Micro Electro-Mechanical Systems) sensors used in a pressure sensor or an acceleration sensor and the like have become known.

Semiconductor sensor devices in which the MEMS sensor is mounted are used in various fields such as automotive parts, game machines, medical devices, and home appliances, and the applications thereof are gradually being extended.

Particularly, in recent years, small-sized MEMS sensors capable of performing high-accuracy detection have been required for mounting the above-mentioned semiconductor sensor device in portable devices.

As one of manufacturing methods for realizing miniaturization, a method is proposed in which the MEMS sensor and an ASIC (Application Specific Integrated Circuit) are laminated, and a packaged structure is realized (see, for example, Patent Document 1 and Patent Document 2).

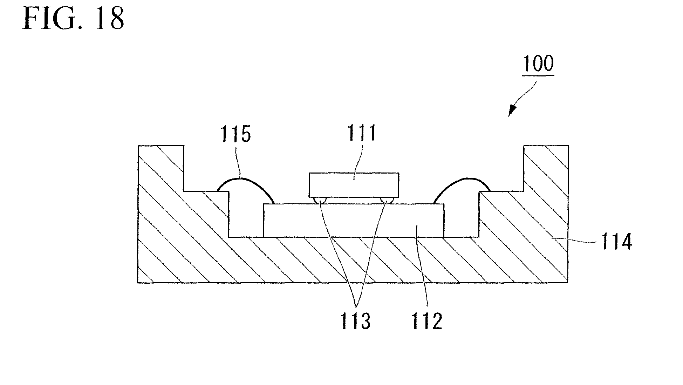

As an example of the packaged structure, a typical structure is shown in FIG. 18.

As shown in FIG. 18, in a semiconductor sensor device 100, a MEMS sensor chip 111 and an ASIC portion 112 are laminated through a bump 113 using flip-chip connection technology.

The ASIC portion 112 and a package housing 114 are electrically connected to each other by a wire 115 in which wire bonding technology is used, and thus a semiconductor sensor device package is formed.

In such a semiconductor sensor device 100, an electrode pad formed in the MEMS sensor chip 111 and an electrode pad, formed in the ASIC portion 112, that corresponds to the electrode pad of the MEMS sensor chip 111 are electrically connected to each other by the conductive bump 113.

In this structure, it is possible to realize considerable miniaturization compared to the connection in which wire bonding technology is used.

However, when the MEMS sensor chip 111 and the ASIC portion 112 are joined to each other using only a bump, there is a concern that peeling may occur between both components due to deterioration of the joint strength.

In addition, there is a concern that cracks may be generated in a bump due to thermal stress generated between both chips, and the joint portion may be broken.

As a structure for suppressing such peeling or breakage, a structure is known in which an underfill material is inserted between the MEMS sensor chip 111 and the ASIC portion 112.

However, when the MEMS sensor chip 111 and the ASIC portion 112 are joined to each other using flip-chip connection technology, the joint surface in a flip-chip connection structure is located at the operational surface of the MEMS sensor chip 111.

For this reason, it is generally difficult to use an underfill material.

For this reason, it is important to obtain high connection reliability through a junction structure in which only a bump is used.

### PRIOR ART DOCUMENTS

### PATENT DOCUMENTS

[Patent Document 1] Japanese Unexamined Patent Application, First Publication No. 2007-180201
[Patent Document 2] Japanese Unexamined Patent Application, First Publication No. 2007-248212

### DISCLOSURE OF INVENTION

### PROBLEMS TO BE SOLVED BY THE INVENTION

On the other hand, in recent years, highly functional electronic devices have remarkably progressed, and the MEMS sensors or the semiconductor sensor devices have also become sophisticated and complicated.

A system in package (SiP) having a high functionality is known in which a plurality of semiconductor devices is integrally packaged and a higher density is realized.

Even for such a system in a package, mounting of the MEMS sensor and the like will be considered from now on, and the type or the number of the MEMS sensors will gradually increase.

From such circumstances, in the future, it is considered that the improvement in the yield in a mounting (packaging) step and the reduction in mounting costs associated therewith will become more important than ever.

In order to improve the yield in a mounting step and reduce mounting costs, it is necessary to improve the yield in each of the semiconductor devices or the semiconductor sensors.

In addition, it is necessary to not only improve the yield as mentioned above, but also improve the defective characteristics in a package in which a defect occurs in a mounting step or a completed package.

Consequently, in the package having a defect or the defective characteristics, it is possible to separate the semiconductor chip and the semiconductor sensor chip from each other, and preferable to individually replace a defective chip by a non-defective chip in the semiconductor chip and the semiconductor sensor chip.

Particularly, in order to reduce manufacturing costs and reduce the environmental load with the cost reduction, the semiconductor device or the semiconductor sensor having the above-mentioned configuration is preferable.

The invention is contrived in view of such circumstances, and an object thereof is to provide a semiconductor sensor device having a new structure which is capable of obtaining high connection reliability without using an underfill material, replacing a defective chip by a non-defective chip by separating a semiconductor chip and a semiconductor sensor chip from each other after the semiconductor chip and the semiconductor sensor chip are connected to each other by a connection component, and achieving reduction in manufacturing costs and reduction in the environmental load.

### MEANS FOR SOLVING THE PROBLEMS

In order to achieve the above-mentioned object, a semiconductor sensor device of a first aspect according to the invention includes: a semiconductor sensor chip that includes a first substrate, a sensor circuit formed on the first substrate, a first conductive portion electrically connected to the sensor circuit, and a first redistribution layer electrically connected to the first conductive portion; a semiconductor chip that includes a second substrate, a processing circuit, formed on the second substrate, that processes an electrical signal output from the sensor circuit, a second conductive portion electrically connected to the processing circuit, and a second redistribution layer electrically connected to the second conductive portion; and a conductive connection component that electrically connects the first redistribution layer and the second redistribution layer.

In the semiconductor sensor device of the first aspect, at least one of the thickness of the first redistribution layer and the thickness of the second redistribution layer is 8 to 20 µm.

It is preferable that the semiconductor sensor device of the first aspect according to the invention further include a first buffer layer which be disposed between the first redistribution layer electrically connected to the sensor circuit through the first conductive portion and the sensor circuit, the thickness of the first redistribution layer is 8 to 20 µm.

In the semiconductor sensor device of the first aspect according to the invention, the thickness of the first buffer layer is 5 to 10 µm.

The semiconductor sensor device of the first aspect according to the invention further includes a second buffer layer which is disposed between the second redistribution layer electrically connected to the processing circuit through the second conductive portion and the processing circuit.

In the semiconductor sensor device of the first aspect according to the invention, a linear expansion coefficient of the first substrate and a linear expansion coefficient of the second substrate are the same.

A package of a second aspect according to the invention includes a semiconductor sensor device of the first aspect that includes a semiconductor chip; and a package housing to which the semiconductor chip is bonded.

A module of a third aspect according to the invention includes a semiconductor sensor device of the first aspect that includes a semiconductor chip; and a module substrate to which the semiconductor chip is bonded.

An electronic device of a fourth aspect according to the invention includes the semiconductor sensor device.

An electronic device of a fifth aspect according to the invention includes the package.

An electronic device of a sixth aspect according to the invention includes the module.

A method of manufacturing a semiconductor sensor device of a seventh aspect according to the invention includes the steps of: preparing a semiconductor sensor chip that includes a first substrate, a sensor circuit formed on the first substrate, a first conductive portion electrically connected to the sensor circuit, and a first redistribution layer electrically connected to the first conductive portion; preparing a semiconductor chip that includes a second substrate, a processing circuit, formed on the second substrate, that processes an electrical signal output from the sensor circuit, a second conductive portion electrically connected to the processing circuit, and a second redistribution layer electrically connected to the second conductive portion; forming a first protective layer so as to cover the first redistribution layer, and forming a first exposed portion by removing a portion of the first protective layer so that the first redistribution layer is exposed; forming a conductive connection component on the first exposed portion; forming a second protective layer so as to cover the second redistribution layer, and forming a second exposed portion by removing a portion of the second protective layer so that the second redistribution layer is exposed; and electrically connecting the conductive connection component and the second exposed portion.

A method of manufacturing a package of an eighth aspect according to the invention using the method of manufacturing a semiconductor sensor device of the seventh aspect includes the steps of: bonding the semiconductor chip in a package housing; and electrically connecting a conductive portion which is not connected to the second exposed portion and the package housing.

A method of manufacturing a module of a ninth aspect according to the invention using the method of manufacturing a semiconductor sensor device of the seventh aspect includes the steps of: bonding the semiconductor chip to a module substrate; and electrically connecting a conductive portion which is not connected to the second exposed portion and the module substrate.

### EFFECTS OF THE INVENTION

In the semiconductor sensor device of the first aspect according to the invention, the first redistribution layer electrically connected to the sensor circuit of the semiconductor sensor chip through an input/output electrode portion (first conductive portion), and the second redistribution layer electrically connected to the processing circuit of the semiconductor chip through an input/output electrode portion (second conductive portion) are electrically connected to each other through the conductive connection component.

In such a configuration, the joint portion of both chips is joined directly by the conductive connection component without using an underfill material, a material of the joint portion is diffused between the connection component and the redistribution layer, and an alloy layer is formed at the joint interface.

For this reason, when a defective chip is found in the mounted semiconductor sensor device, it is possible to easily separate the semiconductor chip and the semiconductor sensor chip in the alloy portion (alloy layer) by melting the connection component.

In addition, it is possible to replace a chip determined to be defective by a non-defective chip in the semiconductor sensor chip or the semiconductor chip.

In this configuration, the thickness of the alloy layer is 5 µm or so.

For this reason, at least one of the thickness of the first redistribution layer and the thickness of the second redistribution layer is 8 to 20 µm. Therefore, even when the a portion of the film thickness of the redistribution layer (first redistribution layer or second redistribution layer) is lost at the time of removing a defective chip in the alloy portion, it is possible to maintain the sufficient thickness for joining a newly non-defective chip.

Therefore, according to the invention, since a defective chip can be individually replaced by a non-defective chip, it is possible to obtain the semiconductor sensor device capable of improving the yield ratio in a mounting step even in a high-density SiP, reducing manufacturing costs, and realizing the reduction in the environmental load.

In the semiconductor sensor device of the first aspect according to the invention, the thickness of the first redistribution layer is 8 to 20 µm, and an insulating layer is disposed as the first buffer layer between the first redistribution layer and the sensor circuit.

This insulating layer has a function of absorbing stress. Therefore, even when the thickness of the first redistribution layer is large, distortion generated in the first redistribution layer is difficult to be transferred to the sensor circuit.

As a result, the influence on the sensor circuit caused by the distortion generated in the first redistribution layer is reduced, and thus the stable sensor characteristics can be obtained.

In addition, since the first buffer layer is provided, the joint portion in which the semiconductor chip and the semiconductor sensor chip are joined to each other at a desired position can be disposed on the first redistribution layer without being limited to the side directly above the input/output electrode portion (first conductive portion).

For this reason, the degree of freedom of the design of the semiconductor sensor device is improved.

Therefore, according to the invention, the sensor characteristics which are hardly influenced by the stress and hence stable are obtained, whereby it is possible to provide the semiconductor sensor device including a mounting structure having a high degree of freedom without being limited by the structure, the size, or the like of the laminated semiconductor chip or the semiconductor sensor chip.

In the semiconductor sensor device of the first aspect according to the invention, since the thickness of the first buffer layer is 5 to 20 µm, it is possible to obtain an effect of more efficiently releasing the stress.

Therefore, since the influence on the sensor circuit caused by the stress is remarkably reduced, it is possible to provide a semiconductor sensor device in which the stable sensor characteristics are always secured without depending on the number of operations for replacing a defective chip with a non-defective chip.

In the semiconductor sensor device of the first aspect according to the invention, the second buffer layer is disposed between the second redistribution layer electrically connected to the processing circuit of the semiconductor chip and the processing circuit.

In this configuration, since the joint portion in which the semiconductor chip and the semiconductor sensor chip at a desired position are joined to each other can be disposed on the second redistribution layer without being limited to the side directly above the input/output electrode portion (second conductive portion), the degree of freedom of the design of the semiconductor sensor device is further improved.

Therefore, according to the embodiment, in the chip-size package composed of small-sized chips, it is possible to provide the semiconductor sensor device including a mounting structure having a high degree of freedom.

In the semiconductor sensor device of the first aspect according to the invention, the linear expansion coefficient of the first substrate and the linear expansion coefficient of the second substrate are the same.

In this configuration, it is possible to effectively reduce the variation in the characteristics of the semiconductor sensor chip due to the stress in the laminated structure composed of the semiconductor chip and the semiconductor sensor chip.

Therefore, according to the invention, it is possible to provide the semiconductor sensor device having a structure which is hardly influenced by the stress and is excellent in long-term stability.

In the package of the second aspect according to the invention, the semiconductor sensor device mentioned above is mounted, and the semiconductor chip and the package housing are bonded to each other.

In this configuration, the stress generated in the package housing at the time of mounting the first substrate and the second substrate is transferred to the semiconductor sensor chip through the semiconductor chip and the connection component.

That is, it is possible to reduce the influence on the semiconductor sensor chip caused by the stress.

Therefore, it is possible to provide a package having a structure which is excellent in long-term stability.

In the module of the third aspect according to the invention, the semiconductor sensor device mentioned above is mounted, and the semiconductor chip and the module substrate are bonded to each other.

In this configuration, the stress generated in the module substrate at the time of mounting the first substrate and the second substrate is transferred to the semiconductor sensor chip through the semiconductor chip and the connection component.

That is, it is possible to reduce the influence on the semiconductor sensor chip caused by the stress.

Therefore, it is possible to provide a module having a structure which is excellent in long-term stability.

The electronic device of the fourth aspect according to the invention includes the above-mentioned semiconductor sensor device.

The electronic device of the fifth aspect according to the invention includes the above-mentioned package.

The electronic device of the sixth aspect according to the invention includes the above-mentioned module.

In this configuration, it is possible to adopt the semiconductor sensor chip of which the film thickness is reduced and to reduce the height of the package or the module including this semiconductor sensor chip. Therefore, it is possible to miniaturize the electronic device in which the semiconductor sensor device, the package, or the module is mounted, and to reduce the thickness of the electronic device.

In the method of manufacturing a semiconductor sensor device of the seventh aspect according to the invention, the semiconductor sensor chip is prepared, and the first protective layer is formed so as to cover the first redistribution layer.

In addition, the first exposed portion is formed by removing a portion of the first protective layer so that the first redistribution layer is exposed.

In addition, the conductive connection component (for example, solder bump) is formed on the first exposed portion.

In addition, the semiconductor chip is prepared, and the second protective layer is formed so as to cover the second redistribution layer.

In addition, the second exposed portion is formed by removing a portion of the second protective layer so that the second redistribution layer is exposed.

In addition, the conductive connection component and the second exposed portion are electrically connected to each other.

According to this method, it is possible to efficiently manufacture the semiconductor sensor device having a structure in which the semiconductor sensor chip and the semiconductor chip are coupled to each other through the solder bump.

The method of manufacturing a package of the eighth aspect according to the invention includes the steps of bonding the semiconductor chip to a package housing and electrically connecting a conductive portion which is not connected to the second exposed portion and the package housing, using the method of manufacturing a semiconductor sensor device of the seventh aspect.

According to this method, the conductive portion which is not connected to the second exposed portion in the existing second conductive portion including the completed semiconductor sensor device is used as an external connection portion.

In this configuration, it is possible to easily electrically connect the semiconductor sensor device and the package housing by using the related art such as wire bonding technology.

The method of manufacturing a module of the ninth aspect according to the invention includes the steps of bonding the semiconductor chip to a module substrate and electrically connecting a conductive portion which is not connected to the second exposed portion and the module substrate, using the method of manufacturing a semiconductor sensor device of the seventh aspect.

According to this method, the conductive portion which is not connected to the second exposed portion in the existing second conductive portion including the completed semiconductor sensor device is used as an external connection portion.

In this configuration, it is possible to easily electrically connect the semiconductor sensor device and the module substrate by using the related art, for example, wire bonding technology.

### BRIEF DESCRIPTION OF THE DRAWINGS

FIG. 1A is a cross-sectional view illustrating an embodiment of a semiconductor sensor device according to the invention.
FIG. 1B is a plan view illustrating the embodiment of the semiconductor sensor device according to the invention.
FIG. 2A is a cross-sectional view illustrating a pressure sensor portion in detail.
FIG. 2B is a plan view illustrating the pressure sensor portion in detail.
FIG. 3A is a cross-sectional view illustrating an ASIC portion in detail.
FIG. 3B is a plan view illustrating the ASIC portion in detail.
FIG. 4 is a schematic cross-sectional view illustrating an example of a package.
FIG. 5 is a schematic cross-sectional view illustrating an example of a module.
FIG. 6A is a cross-sectional view illustrating an example of a step of manufacturing the pressure sensor portion shown in FIG. 3A.
FIG. 6B is a plan view illustrating an example of a step of manufacturing the pressure sensor portion shown in FIG. 3B.
FIG. 7A is a cross-sectional view illustrating an example of a step of manufacturing the pressure sensor portion shown in FIG. 3A.
FIG. 7B is a plan view illustrating an example of a step of manufacturing the pressure sensor portion shown in FIG. 3B.
FIG. 8A is a cross-sectional view illustrating an example of a step of manufacturing the pressure sensor portion shown in FIG. 3A.
FIG. 8B is a plan view illustrating an example of a step of manufacturing the pressure sensor portion shown in FIG. 3B.
FIG. 9A is a cross-sectional view illustrating an example of a step of manufacturing the pressure sensor portion shown in FIG. 3A.
FIG. 9B is a plan view illustrating an example of a step of manufacturing the pressure sensor portion shown in FIG. 3B.
FIG. 10A is a cross-sectional view illustrating an example of a step of manufacturing the ASIC portion shown in FIG. 3A.
FIG. 10B is a plan view illustrating an example of a step of manufacturing the ASIC portion shown in FIG. 3B.
FIG. 11A is a cross-sectional view illustrating an example of a step of manufacturing the ASIC portion shown in FIG. 3A.
FIG. 11B is a plan view illustrating an example of a step of manufacturing the ASIC portion shown in FIG. 3B.
FIG. 12A is a cross-sectional view illustrating an example of a step of manufacturing the ASIC portion shown in FIG. 3A.
FIG. 12B is a plan view illustrating an example of a step of manufacturing the ASIC portion shown in FIG. 3B.
FIG. 13A is a cross-sectional view illustrating an example of a step of manufacturing the ASIC portion shown in FIG. 3A.
FIG. 13B is a plan view illustrating an example of a step of manufacturing the ASIC portion shown in FIG. 3B.
FIG. 14A is a cross-sectional view illustrating an example of a step of manufacturing a package in which the sensor device is mounted.
FIG. 14B is a cross-sectional view illustrating an example of a step of manufacturing the package in which the sensor device is mounted.
FIG. 14C is a cross-sectional view illustrating an example of a step of manufacturing the package in which the sensor device is mounted.
FIG. 15A is a cross-sectional view illustrating an example of a step of manufacturing the package in which the sensor device is mounted.
FIG. 15B is a cross-sectional view illustrating an example of a step of manufacturing the package in which the sensor device is mounted.
FIG. 16A is a cross-sectional view illustrating an example of a step of manufacturing the package in which the sensor device is mounted.
FIG. 16B is a cross-sectional view illustrating an example of a step of manufacturing the package in which the sensor device is mounted.
FIG. 17A is a cross-sectional view illustrating an example of a step of manufacturing the package in which the sensor device is mounted.
FIG. 17B is a cross-sectional view illustrating an example of a step of manufacturing the package in which the sensor device is mounted.
FIG. 18 is a cross-sectional view illustrating a conventional semiconductor sensor device.

### EMBODIMENTS FOR CARRYING OUT THE INVENTION

Hereinafter, an embodiment of the invention will be described with reference to the drawings.

In each of the drawings used in the following description, the scale of each component is appropriately changed in order to set the size of each component to a perceptible one.

### (Semiconductor Sensor Device)

Hereinafter, an embodiment of a semiconductor sensor device according to the invention will be described with reference to the drawings.

In the embodiment, as a MEMS sensor included in a semiconductor sensor chip, a piezoresistive-type semiconductor pressure sensor being 1 mm square and 200 µm thick is used.

In the piezoresistive-type semiconductor pressure sensor, a substrate made of Si (silicon) is used, a thin diaphragm bending depending on the pressure is provided, and a piezoresistive element is provided on the diaphragm.

Such a piezoresistive-type semiconductor pressure sensor detects a change in the pressure as a change in the amount of the output which is output from the piezoresistive element, and detects the pressure.

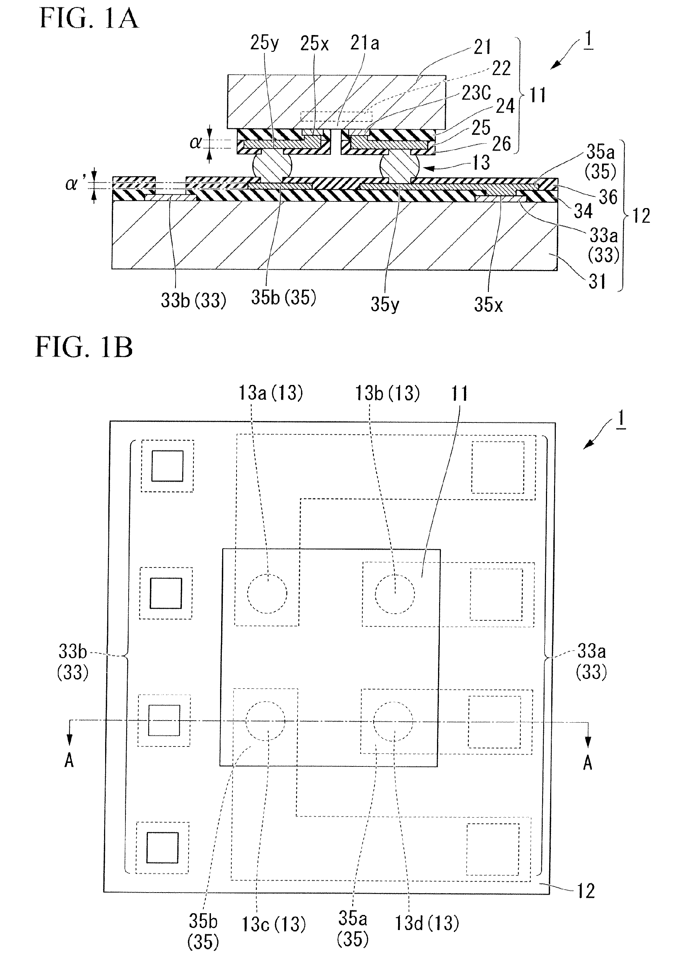

FIGS. 1A and 1B show basic structures of a semiconductor sensor device 1 according to the embodiment. FIG. 1A shows a schematic cross-sectional view thereof, and FIG. 1B shows a schematic plan view thereof.

FIG. 1A shows a cross section taken along the A-A line shown in FIG. 1B.

That is, FIG. 1B is a schematic plan view when seen from the vertical direction of the upper surface of the semiconductor sensor device 1.

In the semiconductor sensor device 1 according to the embodiment, a pressure sensor portion 11 of a semiconductor sensor chip and an ASIC portion 12 of a semiconductor chip are joined by a solder bump 13 of a conductive connection component, and are laminated to each other.

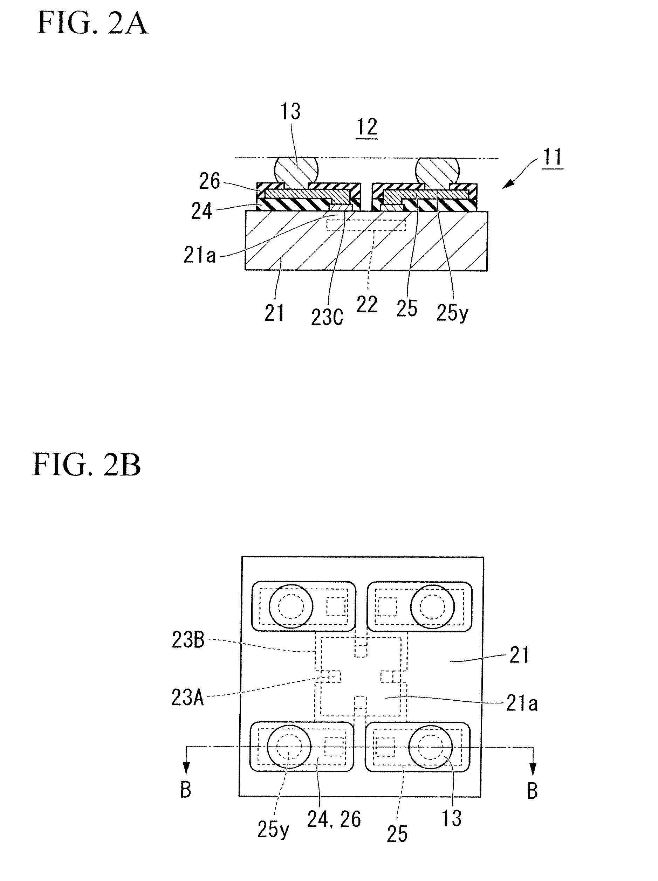

FIGS. 2A and 2B are diagrams illustrating the pressure sensor portion 11 in detail.

In FIGS. 2A and 2B, similarly to FIGS. 1A and 1B, FIG. 2A shows a schematic cross-sectional view, and FIG. 2B shows a schematic plan view.

FIG. 2A shows a cross section taken along the B-B line shown in FIG. 2B.

That is, FIG. 2B is a schematic plan view when seen from the vertical direction of the upper surface of the pressure sensor portion.

Here, in FIGS. 2A and 2B, the surface provided with a circuit and the like is shown as the upper surface for descriptive purposes, and is different from the upper surface of the real structure shown in FIGS. 1A and 1B.

Hereinafter, the pressure sensor portion 11 will be described in detail with reference to FIGS. 2A and 2B.

In a first substrate 21, the internal portion thereof (vicinity of the upper surface) is provided with a void 22, and is provided with a diaphragm portion 21a having a small film thickness.

A piezoresistive element 23A is provided on the diaphragm portion 21a.

A sensor circuit 23B and a first conductive portion 23C functioning as a signal input/output terminal are provided so that the piezoresistive element 23A constitutes a bridge circuit.

In the embodiment, four first conductive portions 23C, referred to as an "I/O pad portion", are provided.

In the embodiment, the piezoresistive element 23A and the peripheral circuit thereof are composed of impurity doping layers.

The sensor circuit 23B and the first conductive portion 23C are composed of, for example, A1 (aluminum) thin films which are appropriately patterned.

A constitutional material of the sensor circuit 23B is not limited to such a material.

The sensor circuit 23B may be formed of an impurity doping layer.

The sensor circuit 23B may be formed of an alloy such as Al-Si or metals other than Al.

In the outer circumferential region of the first substrate 21 except for the diaphragm portion 21a, a first buffer layer 24 made of, for example, a polyimide resin having a thickness of 10 µm is provided so that at least the first conductive portion 23 is exposed.

Furthermore, a first redistribution layer 25 made of, for example, a Cu (copper) film is provided on the first buffer layer 24 so as to be electrically connected to the first conductive portion 23C.

Here, the first redistribution layer 25 has a portion 25x which is connected to the first conductive portion 23C.

Additionally, as a constitutional material of the first buffer layer 24, other types of insulating resins or insulator thin films may be adopted without being limited to such a material.

As a pattern shape of the first buffer layer 24, a shape is adopted in which a region on which at least the diaphragm portion 21a overlaps the first conductive portion 23C is opened (removed).

In addition, as a constitutional material of the first redistribution layer 25, other metals may be adopted without being limited to the material as mentioned above.

In addition, as a structure of the first redistribution layer 25, a laminated structure made of a plurality of metal layers different from each other may be adopted without being limited to a single layer structure made of a single material.

A first protective layer 26 is formed on the first redistribution layer 25 so as to cover at least the first redistribution layer 25.

A portion of the first redistribution layer 25 is opened (removed) so as to be exposed, and thus a first exposed portion 25y for providing the solder bump 13 is formed.

The first exposed portion 25y is referred to as a "first land portion".

As a constitutional material of the first protective layer 26, for example, a polyimide resin is used.

The shape of the first protective layer 26 is the same as the shape of the first buffer layer 24.

In addition, when the first land portion 25y is circular, the opening diameter, that is, the land diameter (diameter of the first land portion 25y) is, for example, 150 µm.

Additionally, as a constitutional material of the first protective layer 26, other types of insulating resins or insulator thin films may be adopted without being limited to such a material.

As a pattern shape of the first protective layer 26, a shape is adopted in which a region on which at least the diaphragm portion 21a overlaps the land portion 25y is opened (removed).

The pattern shape of the first protective layer 26 may be different from the pattern shape of the first buffer layer 24.

In addition, as shown in the embodiment, it is preferable that the first buffer layer 24 and the first protective layer 26 be formed in an island shape so that the end of the pressure sensor portion 11 be covered by the end face of the first buffer layer 24 and the first protective layer 26.

In this configuration, it is possible to remarkably reduce peeling of at least one of the first buffer layer 24 and the first protective layer 26 from the pressure sensor portion 11, especially, the above-mentioned peeling in a dicing step (step of dividing a plurality of pressure sensor portions 11 into individual pieces), and to improve reliability of the pressure sensor portion 11 by improving the yield in a step of manufacturing the pressure sensor portion 11.

In addition, the size of the land diameter is appropriately defined in the range in which the connection strength is sufficiently obtained.

The solder bump 13 is provided on the land portion 25y.

The ASIC portion 12 and the land portion 25y are electrically connected to each other through the solder bump 13.

As a constitutional material of the solder bump 13, for example, a Sn-Ag-Cu based lead-free solder is used.

Additionally, the constitutional material of the solder bump 13 is not limited thereto, and may be a material having another composition.

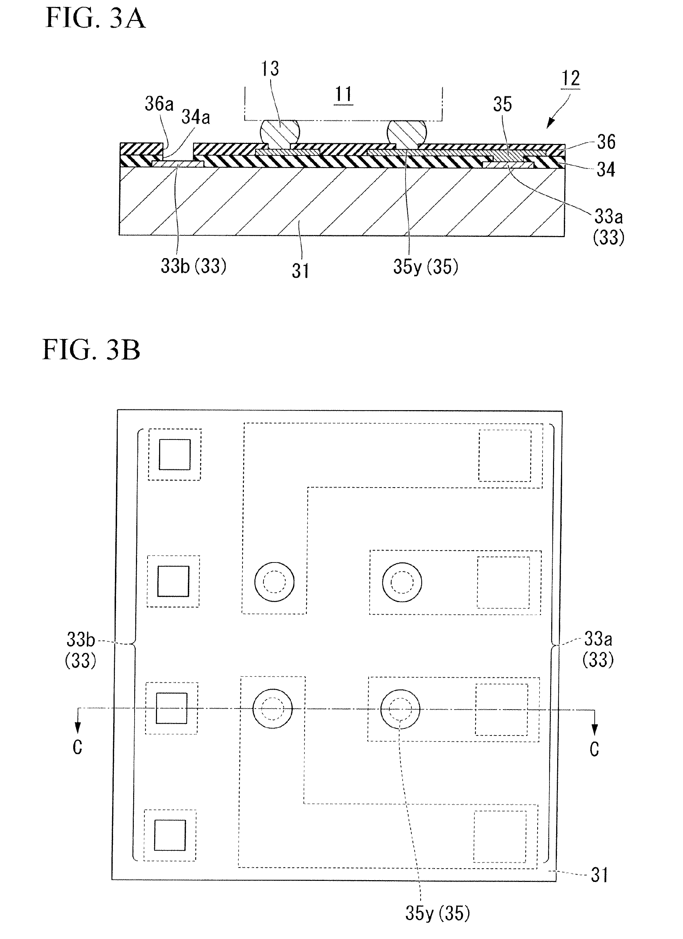

FIGS. 3A and 3B are diagrams illustrating the ASIC portion 12 in detail.

In FIGS. 3A and 3B, similarly to FIGS. 1A and 1B, FIG. 3A shows a schematic cross-sectional view, and FIG. 3B shows a schematic plan view.

FIG. 3A shows a cross section taken along the C-C line shown in FIG. 3B.

That is, FIG. 3B is a schematic plan view when seen from the vertical direction of the upper surface of the ASIC portion.

Hereinafter, the ASIC portion 12 will be described in detail with reference to FIGS. 3A and 3B.

The ASIC portion 12 includes a second substrate 31, a second conductive portion 33, and a second buffer layer 34.

An output amplifier circuit (not shown), a temperature compensation circuit or the like (not shown), and a second conductive portion 33 are provided on the second substrate 31.

The second conductive portion 33 functions as a signal input/output terminal, and is referred to as an "I/O pad portion".

In FIGS. 3A and 3B, eight second conductive portions 33 are provided.

In addition, the second buffer layer 34 is provided on the second substrate 31 so as to cover the end of the second conductive portion 33, and to open a portion of the second conductive portion 33.

In the embodiment, as the ASIC portion 12, for example, a substrate being 2 mm square and 200 µm thick is used.

The second buffer layer 34 is made of, for example, a polyimide resin having a thickness of 10 µm, and is patterned so that at least the second conductive portion 33 is opened.

Additionally, as a constitutional material of the second buffer layer 34, other types of insulating resins or insulator thin film may be adopted without being limited to such a material.

As a pattern shape of the second buffer layer 34, a shape in which a region overlapping the second conductive portion 33 is opened (removed) is adopted.

A second redistribution layer 35 (35a, 35b) made of, for example, a Cu film electrically connected to the second conductive portion 33 is formed on the second conductive portion 33 (four second conductive portion groups 33a disposed at a right half, for descriptive purposes, in FIGS. 3A and 3B) connected to the pressure sensor.

Here, the second redistribution layer 35 has a portion 35x connected to the second conductive portion 33.

Additionally, as a constitutional material of the second redistribution layer 35, other metals may be adopted without being limited to the material as mentioned above.

In addition, as a structure of the second redistribution layer 35, a laminated structure made of a plurality of metal layers different from each other may be adopted without being limited to a single layer structure made of a single material.

In addition, the second conductive portion 33 (four second conductive portion groups 33b disposed at a left half, for descriptive purposes, in FIGS. 3A and 3B) used for inputting and outputting signals between the external device and the ASIC portion 12 is disposed in the ASIC portion 12.

A second protective layer 36 is formed on the second redistribution layer 35 so as to cover at least the second redistribution layer 35.

A portion of the second redistribution layer 35 is opened (removed) so as to be exposed, and thus a second exposed portion 35y for providing the solder bump 13 is formed.

The second exposed portion 35y is referred to as a "second land portion".

As a constitutional material of the second protective layer 36, for example, a polyimide resin is used.

The second protective layer 36 is formed so as to cover the second buffer layer 34.

In addition, when the second land portion 35y is circular, the opening diameter, that is, the land diameter (diameter of the second land portion 35y) is 150 m fit for the land diameter of the pressure sensor portion 11 laminated on the ASIC portion 12.

Additionally, as a constitutional material of the second protective layer 36, other types of insulating resins or insulator thin films may be adopted without being limited to the material as mentioned above.

As a pattern shape of the second protective layer 36, a shape is adapted in which a region on which at least the second protective layer 36 overlaps the second land portion is opened (removed).

The pattern shape of the second protective layer 36 may be a shape in which the entirety of the second buffer layer 34 is covered.

In addition, it is preferable that the size of the land diameter of the second land portion 35y is appropriately defined, and is the same as that of the land diameter of the first land portion of the pressure sensor portion 11 laminated on the ASIC portion 12 considering a balance in the laminated structure.

The solder bump 13 is joined to the surface of the second land portion 35y, and the pressure sensor portion 11 laminated on the ASIC portion 12 and the ASIC portion 12 are electrically connected to each other.

As seen from the above, in the semiconductor sensor device 1 according to the embodiment, the land portions 25y and 35y electrically connected to the conductive portions 23C and 33 are provided at the positions different from the positions of the conductive portions functioning as an input/output terminal in the pressure sensor portion 11 and the ASIC portion 12.

The pressure sensor portion 11 and the ASIC portion 12 are electrically connected to each other through the connection components formed on the land portions 25y and 35y.

As described above, in the structure of the embodiment, both chips are joined to each other directly through the solder bump without using an underfill material.

Therefore, the pressure sensor portion 11 and the ASIC portion 12 are separated from each other by melting the solder, whereby it is possible to easily replace a defective chip with a non-defective chip.

In the structure of the embodiment, the material of the joint portion is diffused between the solder bump and the redistribution layer, and an alloy layer having a thickness of approximately 5 µm or so is formed at the joint interface.

In the case where the thickness of the redistribution layer is equal to the conventional thickness in the vicinity of the portion in which such an alloy layer is formed, there is a concern that when a defective chip is replaced with a non-defective chip by removing the defective chip from the portion in which the alloy layer is formed, the input/output terminal may be damaged.

Consequently, in the semiconductor sensor device 1 according to the embodiment, at least one of the thickness α of the first redistribution layer 25 and the thickness α' of the second redistribution layer 35, of which the joint portion is composed, is defined as 8 to 20 µm.

By defining the film thickness in this way, it is possible to maintain the thickness of the redistribution layer sufficient to newly join a non-defective chip even when a portion of the redistribution layer is lost at the time of removing a defective chip from the alloy portion.

Therefore, according to the embodiment, it is possible to individually replace a defective chip with a non-defective chip without damaging the main body (the pressure sensor portion 11 and the ASIC portion 12).

For this reason, in the manufacture of a high-density SiP, it is possible to obtain the semiconductor sensor device capable of improving the yield in a mounting step, reducing the manufacturing cost, and realizing the reduction in the environmental load.

Additionally, as mentioned later, in the structure, stress generated in the first redistribution layer 25 is released by providing the first buffer layer 24.

However, when the thickness of the first redistribution layer 25 increases, it is not sufficient to release the stress generated in the first redistribution layer 25 by the first buffer layer, and thus the influence caused by the stress becomes significant.

In addition, as stated in a manufacturing method to be described later, since the first redistribution layer 25 and the second redistribution layer 35 are formed by using a conventionally-used manufacturing methods of a thin film, such as plating, a lot of time is required to form a thick film.

In this case, the manufacturing cost increases, and thus it is not possible to realize the reduction of the environmental load which is an object of the invention.

Consequently, the upper limit of the thicknesses α and α' is defined as 20 µm base on the stress relaxation and the manufacturing cost.

The thickness α of the first redistribution layer 25 is defined as 8 to 20 µm, and the structure is adopted in which the first buffer layer 24 is disposed between the first redistribution layer 25 and the sensor circuit 23B. Therefore, an action of absorbing stress in the first buffer layer 24, and distortion generated in the first redistribution layer 25 is not easily transferred to the sensor circuit even when the thickness of the first redistribution layer 25 increases.

In such a structure, it is preferable that the thickness of the first buffer layer 24 be 5 to 20 µm.

When the thickness is 5 µm or more, the effect of the stress relaxation as mentioned above can be sufficiently obtained.

However, when the buffer layer is formed at a film thickness of more than 20 µm, this is not preferable because the stress generated inside the buffer layer influences the sensor circuit.

Consequently, the thickness of the first buffer layer is defined as 5 to 20 µm.

That is, the thickness of the first redistribution layer 25 is defined as 8 to 20 µm, and the thickness of the first buffer layer is defined as 5 to 20 µm.

Even when the thicknesses of the first redistribution layer and the first buffer layer have any values within each range (that is, even when the combination of any film thicknesses is used) insofar as within the range of the thickness defined in this way, the stress generated in the first redistribution layer 25 is released by the first buffer layer, whereby it is possible to suppress the stress generated inside the first buffer layer, and to suppress the influence on the sensor circuit.

In addition to this, since the first buffer layer 24 is provided, the connection portion (first land portion) 25y between the first redistribution layer 25 and the solder bump 13 can be provided to a desired position, without being limited to the side directly above the connection portion 25x between the first redistribution layer 25 and the first conductive portion 23.

As a result, the joint portion between the semiconductor chip (ASIC portion 12) and the semiconductor sensor chip (pressure sensor portion 11) can be freely disposed without depending on the position of the first conductive portion 23, which leads to the improvement in the degree of freedom of the design of the semiconductor sensor device.

Therefore, according to the embodiment, the sensor characteristics which are hardly influenced by the stress and hence stable are obtained, whereby it is possible to provide the semiconductor sensor device including a mounting structure having a high degree of freedom in accordance with the demand for the external substrate.

In the embodiment, it is preferable to use a structure in which the second buffer layer 34 is disposed between the second redistribution layer 35 and a processing circuit of the ASIC portion 12.

Because of this, the connection portion (second land portion) 35y between the second redistribution layer 35 and the solder bump 13 can be provided to a desired position without being limited to the side directly above the connection portion 35x between the second redistribution layer 35 and the second conductive portion 33.

As a result, the joint portion between the semiconductor chip (ASIC portion 12) and the semiconductor sensor chip (pressure sensor portion 11) can be freely disposed without depending on the position of the second conductive portion 33, which leads to the further improvement in degree of freedom of the design of the semiconductor sensor device.

Therefore, according to the embodiment, in the chip-size package composed of small-sized chips, it is possible to provide the semiconductor sensor device including a mounting structure having a high degree of freedom.

### (Package)

Next, an embodiment of a package in which the sensor device according to the invention is mounted will be described.

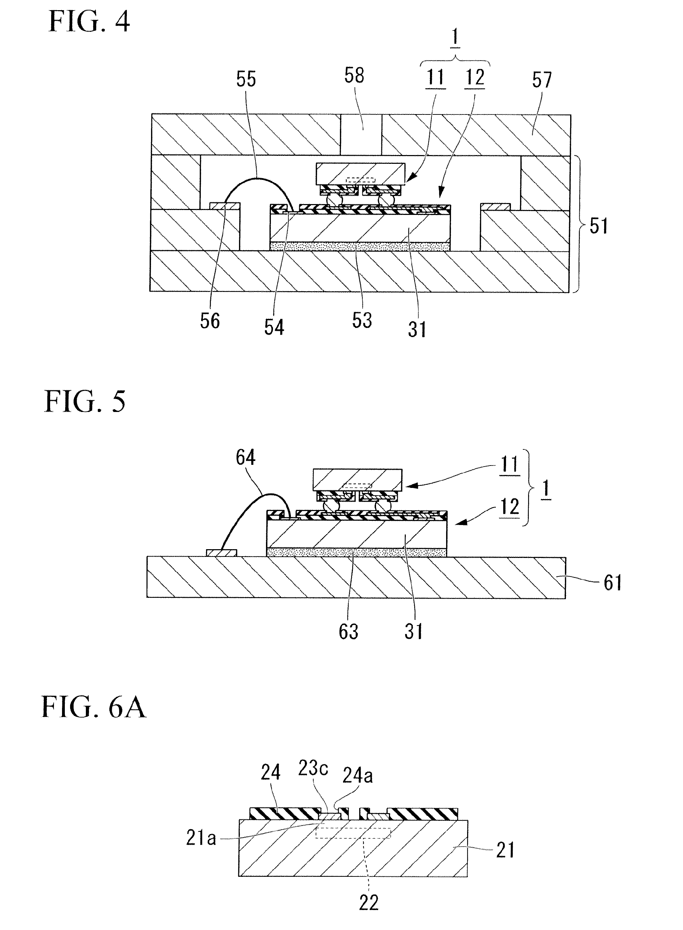

FIG. 4 is a schematic cross-sectional view illustrating an example of a package.

The ASIC portion 12 of the sensor device 1 of the above-mentioned embodiment is bonded to a package housing 51 using a bond 53 and is mounted therein.

As the package housing 51, a three-layer ceramic package being 3 mm square and having a total thickness of 0.8 mm is used.

Additionally, the size of the package housing is not limited thereto, and may be different in size from that of the above-mentioned configuration.

In addition, the structure of the package housing is not limited thereto, and may be a structure different from the above-mentioned three-layer structure.

In addition, a resin package and the like may be appropriately used instead of the ceramic package.

In FIG. 4, an I/O pad 54 (conductive portion) is a pad wired to the external device (external substrate) from the second conductive portions 33 (I/O pads) on the ASIC portion 12 which are not connected to the pressure sensor portion 11, that is, from among the four second conductive portion groups 33b of a left half shown in FIGS. 3A and 3B.

The I/O pad 54 is electrically connected to an electrode pad 56 provided in the package housing 51 by wire bonding technology in which a wire 55 is used.

Furthermore, although not shown in FIG. 4, an interconnection or a through-hole electrode, a backside electrode or a side electrode, and the like are appropriately provided in the package housing 51 so as to be electrically connected to the electrode pad 56, and thus a signal which is output from the sensor device can be extracted to the outside.

In the embodiment, a connection structure is adopted to which wire bonding technology is applied using the wire 55 made of gold (Au) having a diameter of 25 µm, but the embodiment is not limited to such a structure.

A cover 57 having the same size as that of the package housing may be provided, as necessary, to the upper surface of the package housing 51.

In the embodiment, a ceramic cover is used as the cover 57, and the cover 57 is bonded to the package housing 51 using a bond.

An outside air inlet 58 having a size of 3 mm square, a thickness of 200 µm, and a diameter of 30 µm in the central portion of the cover is provided in the ceramic cover.

Additionally, the structure of the cover is not limited to such a structure.

Insofar as functioning as a cover, the cover may have a size or a thickness different from that of the above-mentioned structure.

As a constitutional material of the cover, a resin or a metal and the like can be appropriately used.

As a method of bonding the cover 57 to the package housing 51, other methods such as a method of using a solder and the like may be used.

The diameter of the outside air inlet is appropriately defined.

The position of the outside air inlet is not limited to the central portion, and may be, for example, the lateral side.

In addition, the outside air inlet may be provided not in the cover 57, but in the package housing 51.

Additionally, in the embodiment, when the cover 57 is provided on the upper surface of the package housing 51, it is preferable that the height of the wire 55 formed in a loop shape is made low so as not to be in contact with the package housing 51, and that the height thereof is lower than the height between the upper surface of the ASIC portion 12 and the upper surface of the pressure sensor portion 11.

### (Module)

Next, a description will be made of an embodiment of a module in which the sensor device according to the invention is mounted.

FIG. 5 is a schematic cross-sectional view illustrating an example of a module.

The ASIC portion 62 of the sensor device of the above-mentioned embodiment is bonded onto a module substrate 61 using a bond 63, and is mounted thereon.

The ASIC portion 62 and the module substrate 61 are electrically connected to each other by wire bonding technology in which a wire 64 is used.

Specifically, as shown in FIG. 5, an I/O pad (conductive portion) is a pad wired to the module substrate 61 (external substrate) from the second conductive portions 33 (I/O pads) on the ASIC portion 12 which are not connected to the pressure sensor portion 11, that is, from among the four second conductive portion groups 33b of the left half shown in FIGS. 3A and 3B.

The I/O pad (conductive portion) is electrically connected to an electrode pad provided to the module substrate 61 by wire bonding technology in which the wire 64 is used.

An electronic device (not shown) or a chip part (not shown) may be mounted on the module substrate 61.

As shown in FIGS. 4 and 5, in the package and the module according to the embodiment, the ASIC of the sensor device is bonded to the package housing or the module substrate, and is mounted therein.

With such a configuration, it is possible to reduce the influence of the stress generated in the package housing 51 or the module substrate 61 on the pressure sensor laminated on the ASIC.

Particularly, in the embodiment, in the structure in which the pressure sensor made of Si and the ASIC are laminated, since both components have the same linear expansion coefficient, the fluctuation in the characteristics of the pressure sensor by the stress generated in each component can be effectively reduced.

In the embodiment, although the thickness of the ASIC can be appropriately defined, it is preferable that the ASIC has a thickness of 100 µm or more, as a result of the systematic examination in order to effectively reduce the influence of the stress mentioned above.

In addition, when the pressure sensor made of Si is used as a MEMS sensor as in the embodiment, there is a problem that irradiation of the circuit side with light from the outside causes an output of the MEMS sensor to fluctuate due to the generation of excited carriers.

On the other hand, in the sensor device of the embodiment, the pressure sensor portion and the ASIC portion are laminated so that the circuit side of the pressure sensor portion and the ASIC portion are opposite to each other.

For this reason, it is possible to prevent the circuit side from being irradiated with light directly from the outside.

In addition, in the cover 57 provided on the upper surface of the package housing 51, the position in which the outside air inlet is provided is optionally determined.

### (Method of Manufacturing Semiconductor Sensor Device)

Hereinafter, description will be given of an embodiment of a method of manufacturing the sensor device according to the invention.

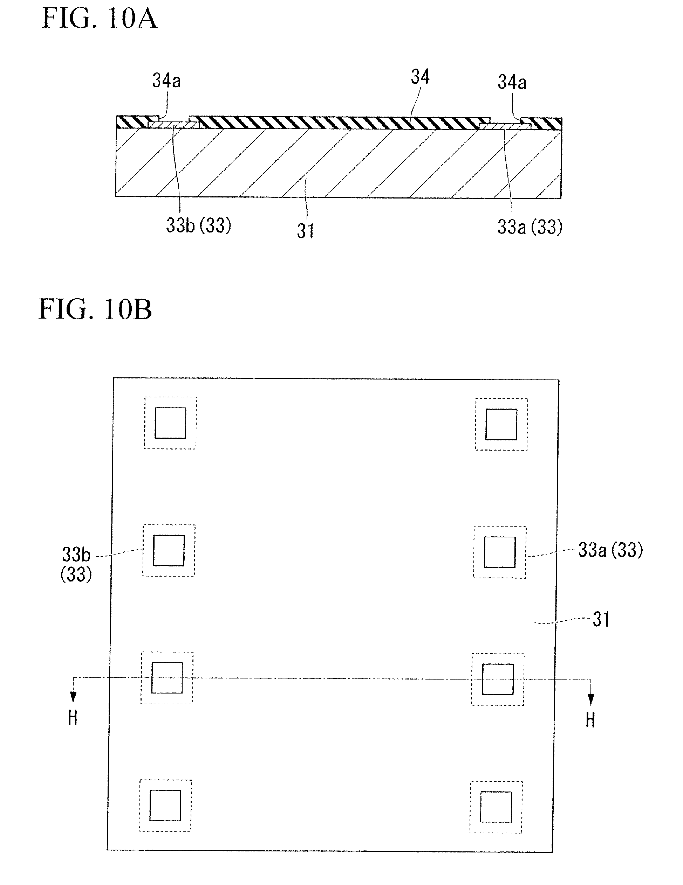

A method of forming the pressure sensor portion will be described with reference to FIGS. 6A to 9B, and the ASIC portion will be described with reference to FIGS. 10A to 13B.

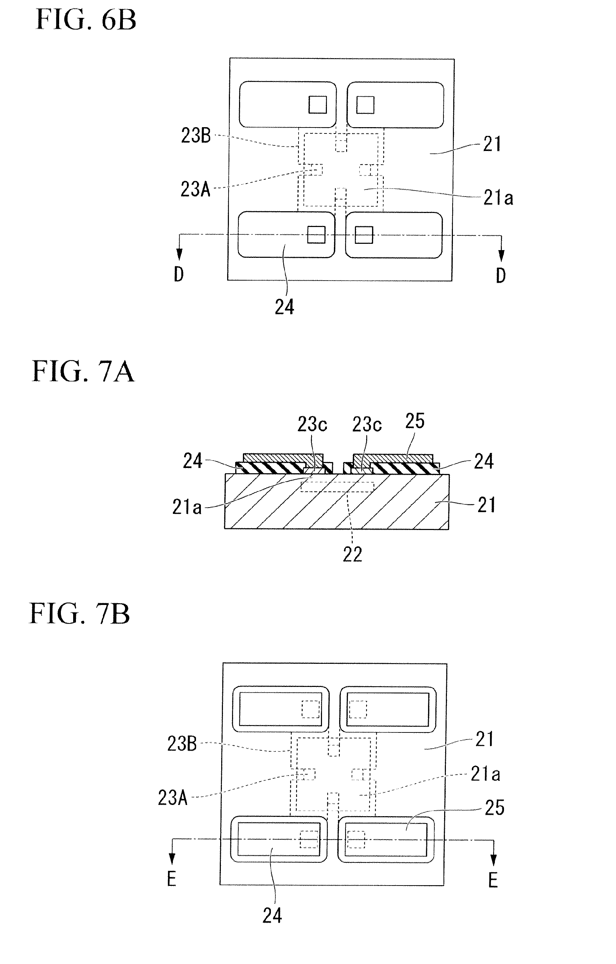

FIGS. 6A to 13B show schematic cross-sectional views (FIGS. 6A, 7A, 8A, 9A, 10A, 11A, 12A, and 13A) and schematic plan views (FIGS. 6B, 7B, 8B, 9B, 10B, 11B, 12B, and 13B), similarly to FIGS. 1A and 1B.

FIGS. 6A, 7A, 8A, 9A, 10A, 11A, 12A, and 13A are cross-sectional views, respectively, taken along the lines (D-D line to K-K line) in FIGS. 6B, 7B, 8B, 9B, 10B, 11B, 12B, and 13B.

That is, FIGS. 6B, 7B, 8B, 9B, 10B, 11B, 12B, and 13B are schematic plan views when the upper surface of the ASIC portion is seen from the vertical direction.

Hereinafter, reference will be made to FIGS. 6A to 9B to describe an example of a step of manufacturing the pressure sensor portion shown in FIGS. 3A and 3B.

The detailed structure of the pressure sensor portion is described in the above-mentioned embodiment, and thus the detailed description thereof will be omitted below.

Additionally, in each of the drawings, the manufacturing step is described by showing the manufacture of one chip. However, in the practical process flow, a plurality of chips is formed on the wafer by the manufacturing step described later using the wafer.

First, as shown in FIGS. 6A and 6B, the first substrate 21 of the pressure sensor portion is prepared.

Next, a photosensitive polyimide resin is uniformly applied onto the circuit side of the first substrate 21.

Next, after heat treatment and the like are performed as necessary, exposure treatment and development treatment are performed.

By such steps, the polyimide resin is patterned so as to open at least the upper portion of the diaphragm 21a and the upper portions of the I/O pads 23C (here, four) to be used, that is, so as to form an opening 24a, and the first insulating layer 24 is formed.

Here, four first buffer layers 24 having an island shape at a thickness of 10 µm are formed in the peripheries of each of the I/O pads.

Additionally, the material of the first buffer layer 24 is not limited to polyimide, and insulating resins or insulator thin films other than polyimide may be adopted as a material thereof.

In addition, as a pattern shape of the first buffer layer 24, any shape may be adopted as long as at least the diaphragm portion and the I/O pad are opened.

In addition, when the first buffer layer 24 functions as an insulating layer, the thickness of the first buffer layer 24 is not limited.

Next, as shown in FIGS. 7A and 7B, the first redistribution layer 25 is formed on the first buffer layer 24 so as to be electrically connected to the I/O pad.

In the embodiment, after a seed layer is formed on the whole surface of the wafer, a Cu film having a thickness of 10 µm is formed by a plating method, and then the first redistribution layer 25 is formed by appropriately patterning the film.

Additionally, as a method of forming the first redistribution layer 25, for example, a method of overlapping a plurality of metal layers different from each other may be used without being limited to the above-mentioned method.

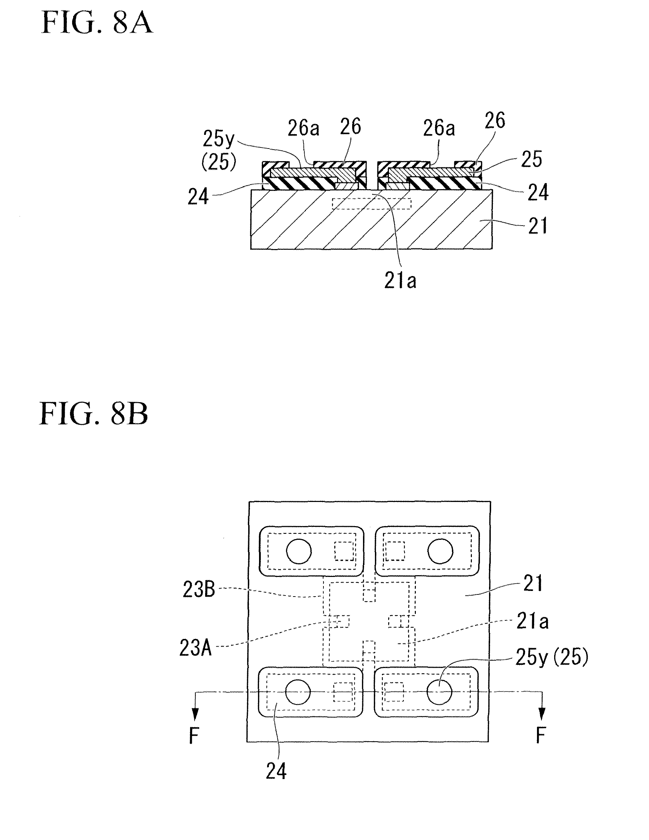

Next, as shown in FIGS. 8A and 8B, a photosensitive polyimide resin is uniformly applied onto the first substrate 21, the first buffer layer 24, and the first redistribution layer 25.

Next, after heat treatment and the like are performed as necessary, exposure treatment and development treatment are performed.

The first protective layer 26 is formed so as to cover at least the first redistribution layer 25 by such steps.

A portion of the first protective layer 26 is opened (removed) so that the first redistribution layer 25 is exposed, the opening 26a is formed, and the first land portion 25y (25) used for providing a solder bump is formed.

In the embodiment, the island-shaped first protective layer 26 having the same size as that of the first buffer layer 24 is formed.

The land diameter of the first land portion 25y (25) is 150 µm.

Additionally, the material of the first protective layer 26 is not limited to polyimide, and insulating resins or insulator thin films other than polyimide may be adopted as a material thereof.

In addition, the pattern shape of the first protective layer 26 may be any shape as long as at least the diaphragm portion and the land portion are opened, and pattern shapes different from the first buffer layer 24 may be adopted as a pattern shape thereof.

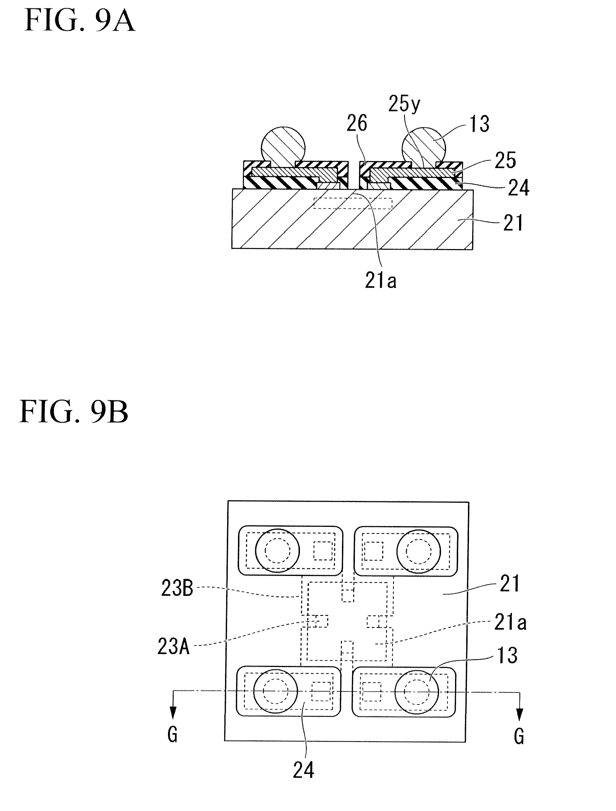

Next, as shown in FIGS. 9A and 9B, the solder bump 13 made of a Sn-Ag-Cu based lead-free solder is provided on the first land portion 25y (25).

In the embodiment, after a solder paste is mask-printed, the solder bump is formed by performing heat treatment.

Additionally, as a material of the solder bump 13, materials made of compositions other than the above-mentioned composition may be adopted.

As a method of forming the solder bump 13, other methods such as a ball mounting method may be used.

In addition, in the embodiment, although the solder bump is provided on the land portion of the pressure sensor portion 11, the solder bump may be provided on the land portion of the ASIC portion 12 described later.

That is, any one or both of the pressure sensor portion 11 and the ASIC portion 12 may be provided with the solder bump.

Hereinafter, reference will be made to FIGS. 10A to 13B to describe an example of a step of manufacturing the ASIC portion shown in FIGS. 3A and 3B.

The detailed structure of the ASIC portion is described in the above-mentioned embodiment, and thus the detailed description thereof will be omitted below.

Additionally, in each of the drawings, the manufacturing step is described by showing one chip. However, in the real step, a plurality of chips is formed on the wafer by the manufacturing step described later using the wafer.

First, as shown in FIGS. 10A and 10B, the second substrate 31 of the ASIC portion is prepared.

Next, a photosensitive polyimide resin is uniformly applied onto the circuit side of the second substrate 31.

Next, after heat treatment is performed as necessary, exposure treatment and development treatment are performed.

By such steps, the polyimide resin is patterned so as to open at least the upper portion of the I/O pads 33 (33a, 33b) to be used, that is, so as to form an opening 34a, and the second buffer layer 34 is formed.

In FIG. 10B, eight I/O pads 33 are formed.

Here, the second buffer layer 24 having a thickness of 10 µm is formed on the whole surface except for the I/O pad.

Additionally, the material of the second buffer layer 34 is not limited to polyimide, and insulating resins or insulator thin films other than polyimide may be adopted as a material thereof.

Furthermore, when the second buffer layer 34 functions as an insulating layer, the thickness of the second buffer layer 34 is not limited.

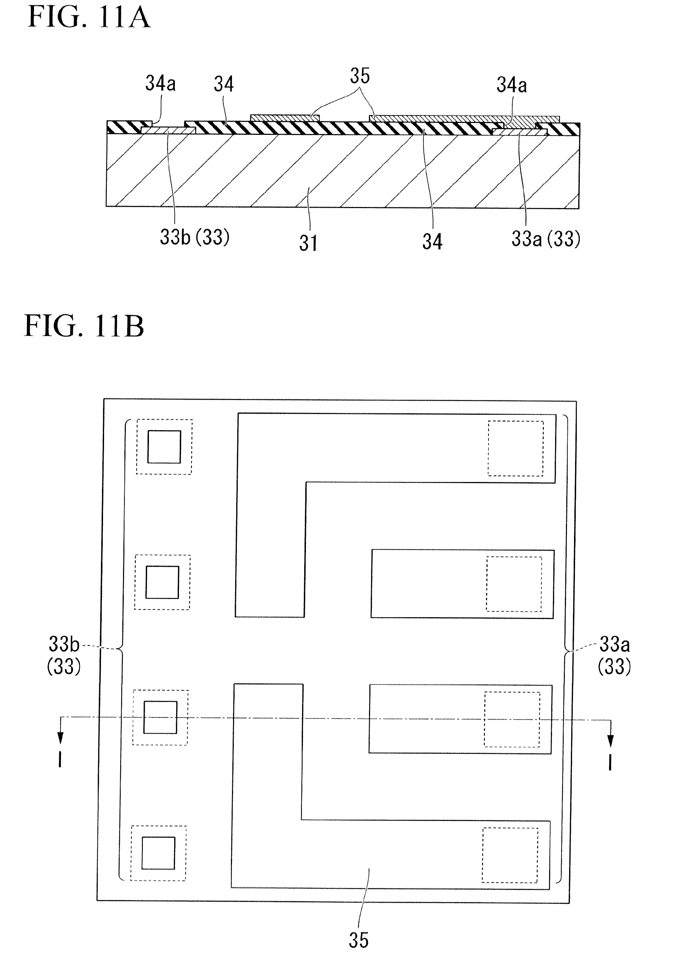

Next, as shown in FIGS. 11A and 11B, the second redistribution layer 35 is formed on the I/O pad (four I/O pad groups 33a (33) of a right half) connected to the pressure sensor portion 11.

The second redistribution layer 35 is electrically connected to four I/O pad groups 33a.

In the embodiment, the second redistribution layer 35 having a thickness of 10 µm is formed by appropriately patterning a copper (Cu) film formed using a plating method.

Additionally, as a material of the second redistribution layer 35, a metal different from the above-mentioned metal may be adopted.

In addition, as a method of forming the second redistribution layer 35, for example, a method of overlapping a plurality of metal layers different from each other may be used without being limited to the above-mentioned method.

In addition, the thickness of the second redistribution layer 35 is not limited.

In addition, in the embodiment, an example of the number of the second redistribution layers 35 or the pattern thereof is shown, and the number of the second redistribution layers 35 or the pattern thereof is appropriately selected depending on the type of the MEMS sensor portion (pressure sensor portion 11) laminated on the ASIC portion 12 or the size thereof and the like.

In the above-mentioned structure, it is preferable that the pattern of the second redistribution layer 35 is defined so that the MEMS sensor laminated on the ASIC portion 12 and the I/O pad (four I/O pad groups 33b (33) of a left half) for inputting and outputting signals to and from the external device do not interfere with each other.

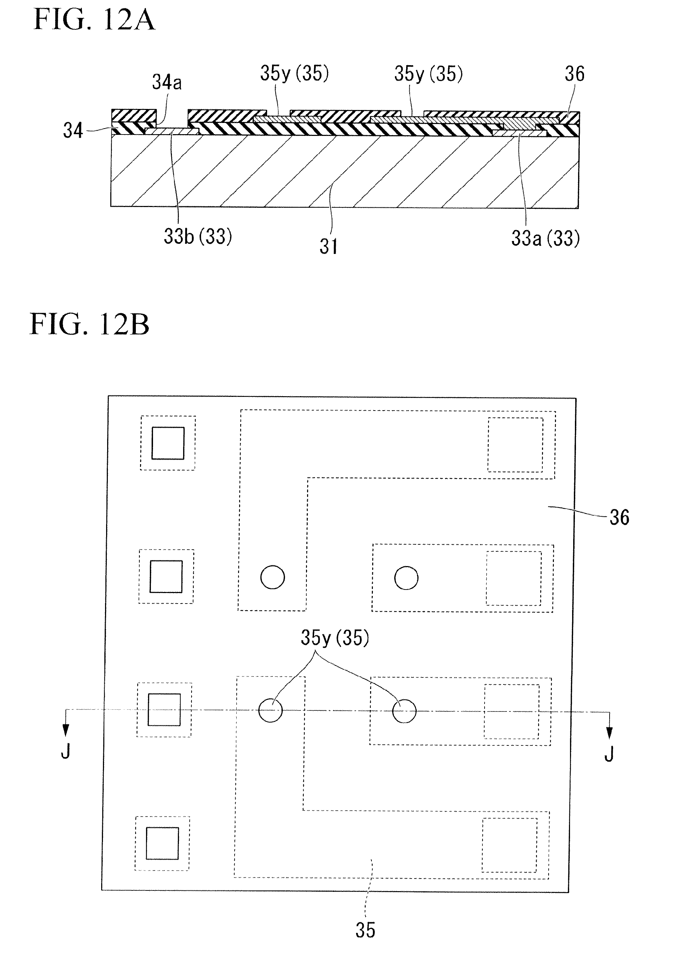

Next, as shown in FIGS. 12A and 12B, the second protective layer 36 is formed on the second redistribution layer 35 so as to cover at least the second redistribution layer 35.

A portion of the second protective layer 36 is opened (removed) so that the second redistribution layer 35 is exposed, and the second land portion 35y (35) which is connected to the solder bump formed in the MEMS sensor portion is formed.

In the embodiment, a photosensitive polyimide resin is uniformly applied onto the I/O pad 33, the second buffer layer 34, and the second redistribution layer 35.

Next, after heat treatment and the like are performed as necessary, exposure treatment and development treatment are performed.

By such steps, the polyimide resin is patterned so that the I/O pad group 33b (33) and the second land portion 35y (35) are opened, and the second protective layer 36 having a thickness of 10 µm is formed.

Additionally, the material of the second protective layer 36 is not limited to polyimide, and insulating resins or insulator thin films other than polyimide may be adopted as a material thereof.

In addition, as a pattern shape of the second protective layer 36, any shape may be adopted as long as at least the I/O pad and the land to be used are opened.

Furthermore, when the second protective layer 36 functions as an insulating layer, the thickness of the second protective layer 36 is not limited.

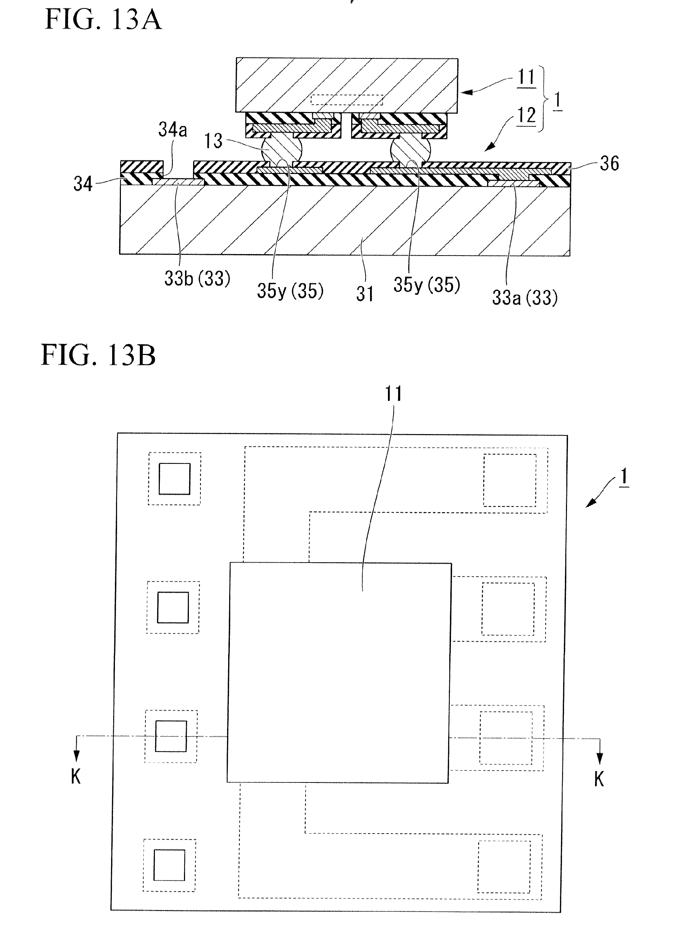

Finally, as shown in FIGS. 13A and 13B, the pressure sensor portion 11 and the ASIC portion 12 are laminated so that the solder bump 13 of the pressure sensor portion 11 and the second land portion 35y (35) are connected to each other, and reflow processing is performed, to thereby complete the sensor device 1.

In the embodiment, a plurality of pressure sensor portions 11 formed by the steps described in FIGS. 13A and 13B is divided into individual pieces to obtain a plurality of individual chips, and a plurality of these chips is mounted on the ASIC wafer (wafer in which a plurality of ASIC portions is formed).

Thereafter, a plurality of ASIC portions formed in the wafer is divided into individual pieces, and the sensor device is manufactured.

Additionally, in the embodiment, a plurality of pressure sensor portions 11 divided into individual pieces and a plurality of ASIC portions 12 divided into individual pieces are previously prepared, and a method of laminating each pressure sensor portion 1 and each ASIC portion 12 may be adopted.

### (Method of Manufacturing Package)

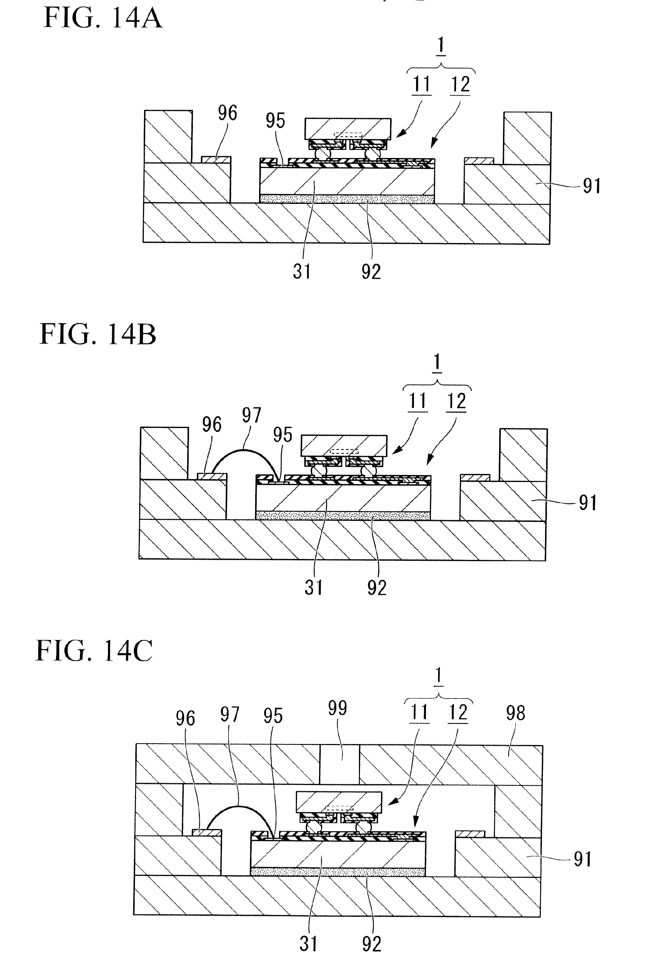

Next, reference will be made to FIGS. 14A to 14C to describe an embodiment of a method of manufacturing a package in which the sensor device according to the invention is mounted.

FIGS. 14A to 14C are schematic cross-sectional views illustrating an example of the method of manufacturing the package arranged in order of steps.

First, as shown in FIG. 14A, a bond 92 is applied to the inside bottom of a package housing 91, and the sensor device 1 is mounted on the package housing 91 so that the second substrate 31 of the ASIC portion 12 included in the sensor device 1 of the embodiment is joined through the bond 92.

Additionally, in the embodiment, although a method of mounting the sensor device 1 in the package housing 91 is used, the invention is not limited to this method.

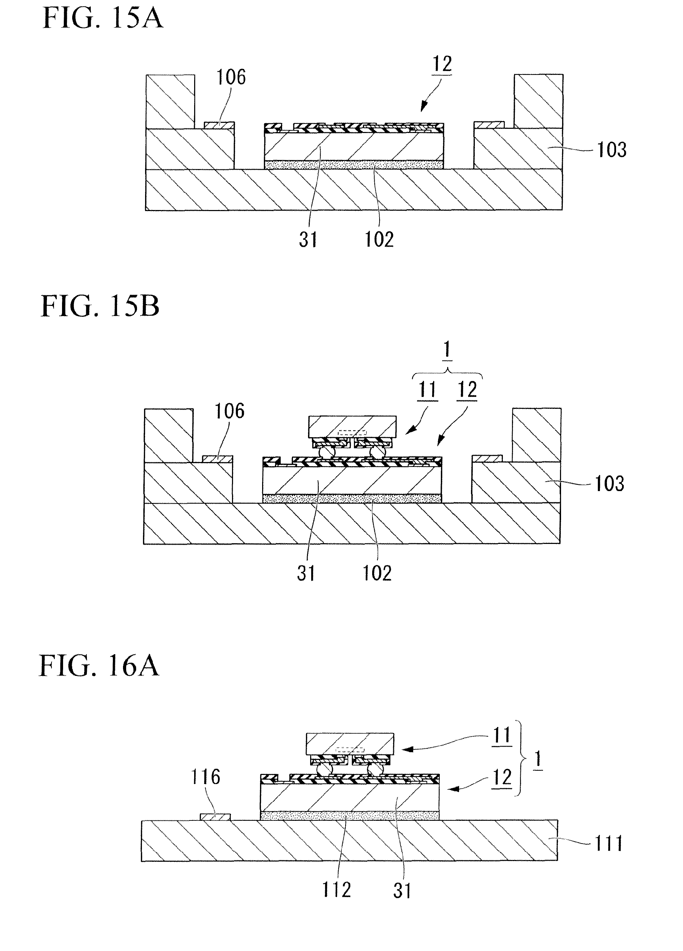

For example, as shown in FIGS. 15A and 15B, the second substrate 31 (FIG. 15A) of the ASIC portion 12 previously divided into individual pieces is mounted in the package housing 103 through a bond 102, and then a method of laminating (FIG. 15B) the pressure sensor portion 11 on the ASIC portion 12 may be used.

Next, as shown in FIG. 14B, an I/O pad 95 (pad connected to the housing 91 (outside)) on the ASIC portion 12 and an electrode 96 provided in the package housing 91 are electrically connected to each other by wire bonding technology in which a wire 97 is used.

In such a connecting step, there is a concern that a film (oxide layer or the like) that causes the defective connection of the I/O pad 95 of the ASIC portion 12 and the wire 97 may be formed on the surface of the I/O pad 95 due to heat treatment for bonding the sensor device 1 to the package housing 91 or heat treatment for laminating the pressure sensor portion 11 on the ASIC portion 12.

Consequently, it is preferable that in order to remove this film and satisfactorily connect the wire 97 and the I/O pad 95, at least the surface of the I/O pad 95 is cleaned using Ar plasma (not shown) and the like before a step of wire bonding.

Finally, as shown in FIG. 14C, a cover 98 is provided on the upper surface of the package housing 91 as necessary.

In the embodiment, the ceramic cover 98, having the same size as that of the package housing, in which an outside air inlet 99 is formed in the central portion is bonded to the package housing using a bond.

Additionally, as a bonding method, another method such as the use of a solder and the like may be used without being limited to the method of using a bond.

In addition, in the embodiment, when the cover 98 is provided on the upper surface of the package housing 91, it is preferable that the height of the wire 97 formed in a loop shape is made low so as not to be in contact with the cover 98, and the height thereof is lower than the height between the upper surface of the ASIC portion 12 and the upper surface of the pressure sensor portion 11.

### (Method of Manufacturing Module)

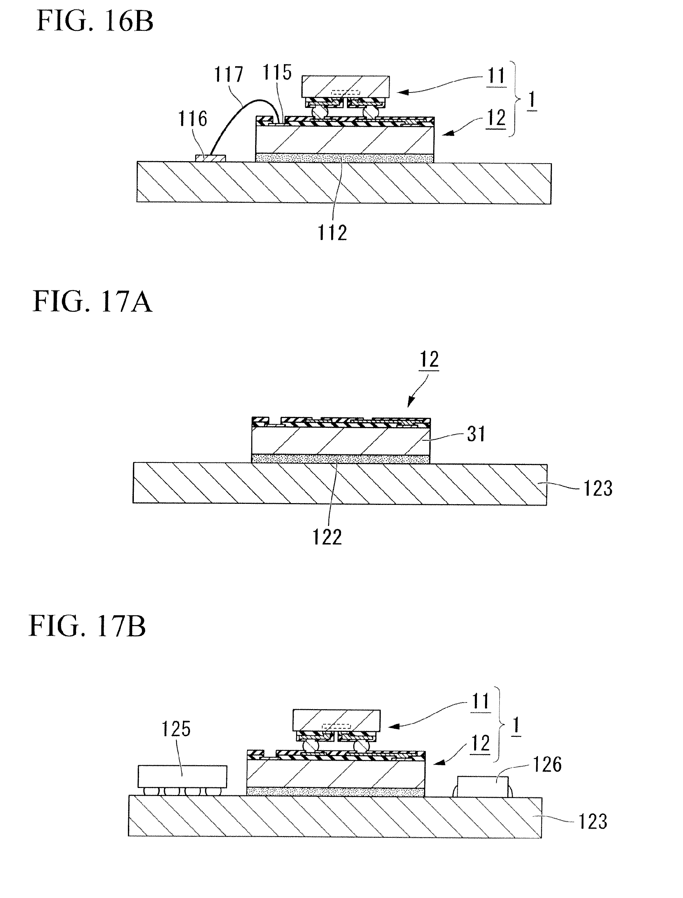

Next, reference will be made to FIGS. 16A and 16B to describe an embodiment of a method of manufacturing a module in which the sensor device according to the invention is mounted.

FIGS. 16A and 16B are schematic cross-sectional views illustrating an example of the method of manufacturing the module arranged in order of steps.

First, as shown in FIG. 16A, a bond 112 is applied to a predetermined position on a module substrate 111, and the sensor device 1 is mounted on the module substrate 111 so that the second substrate 31 of the ASIC portion 12 included in the sensor device 1 of the embodiment is joined through the bond 112.

Next, as shown in FIG. 16B, an I/O pad 115 (pad connected to the module substrate 111 (outside)) on the ASIC portion 12 and a connection terminal 116 of the module substrate 111 are electrically connected to each other by wire bonding technology in which a wire 117 is used.

In such a connecting step, there is a concern that a film (oxide layer or the like) that causes the defective connection of the I/O pad 115 on the ASIC portion 12 and the wire 117 may be formed on the surface of the I/O pad 115 due to heat treatment for bonding the sensor device 1 to the module substrate 111.

Consequently, it is preferable that in order to remove this film and satisfactorily connect the wire 117 and the I/O pad 115, at least the surface of the I/O pad 115 is cleaned using Ar plasma (not shown) and the like before a step of wire bonding.

Additionally, in the embodiment, although a method of mounting the sensor device 1 on the module substrate 111 is used, the invention is not limited to this method.

For example, as shown in FIGS. 17A and 17B, the second substrate 31 (FIG. 17A) of the ASIC portion 12 previously divided into individual pieces may be mounted on a module substrate 123 through a bond 122, and then a method of laminating (FIG. 17B) the pressure sensor portion 11 on the ASIC portion 12 may be used.

In the method shown in FIGS. 17A and 17B, another electronic device 125 or chip part 126 different from the sensor device 1 may be mounted on the module substrate 123 simultaneously with mounting the pressure sensor portion 12 on the module substrate 123, and a plurality of devices may be collectively mounted on the module substrate 123 by reflow processing.

According to this method, the module can be efficiently manufactured.

Additionally, the technical scope of the invention is not limited to the above-mentioned embodiments, and various changes can be added without departing from the scope of the invention.

### INDUSTRIAL APPLICABILITY

The semiconductor sensor device according to the invention may be applied to, for example, a sensor device that includes at least a MEMS sensor such as a pressure sensor or an acceleration sensor, and an ASIC for processing signals generated in the MEMS sensor, and may be suitably applied to various types of electronics parts, particularly, in which reduction or miniaturization of the thickness of the device is required, or a high-density structure and the like are required.

### DESCRIPTION OF THE REFERENCE SYMBOLS

- α:: a thickness of the first redistribution layer
- α':: a thickness of the second redistribution layer
- 1:: semiconductor sensor device
- 11:: a pressure sensor portion (a semiconductor sensor chip)
- 12:: an ASIC portion (a semiconductor chip)
- 13:: solder bump (a conductive connection component)
- 21:: a first substrate
- 22:: a diaphragm portion
- 23:: a first conductive portion
- 24:: a first buffer layer
- 25:: a first redistribution layer
- 26:: a first protective layer
- 31:: a second substrate
- 33:: a second conductive portion
- 34:: a second buffer layer
- 35:: a second redistribution layer
- 36:: a second protective layer

## Claims

1. A semiconductor sensor device comprising:
a semiconductor sensor chip that includes a first substrate, a sensor circuit formed on the first substrate, a first conductive portion electrically connected to the sensor circuit, and a first redistribution layer electrically connected to the first conductive portion;
a semiconductor chip that includes a second substrate, a processing circuit, formed on the second substrate, that processes an electrical signal output from the sensor circuit, a second conductive portion electrically connected to the processing circuit, and a second redistribution layer electrically connected to the second conductive portion; and
a conductive connection component that electrically connects the first redistribution layer and the second redistribution layer,
wherein at least one of the thickness of the first redistribution layer and the thickness of the second redistribution layer is 8 to 20 µm.

2. The semiconductor sensor device according to claim 1, further comprising a first buffer layer which is disposed between the first redistribution layer and the sensor circuit, the first redistribution layer being electrically connected to the sensor circuit through the first conductive portion, wherein
the thickness of the first redistribution layer is 8 to 20 µm.

3. The semiconductor sensor device according to claim 2, wherein the thickness of the first buffer layer is 5 to 10 µm.

4. The semiconductor sensor device according to claims 2 or 3 further comprising
a second buffer layer which is disposed between the second redistribution layer and the processing circuit, the second redistribution layer being electrically connected to the processing circuit through the second conductive portion.

5. The semiconductor sensor device according to any one of claims 1 to 4, wherein
a linear expansion coefficient of the first substrate and a linear expansion coefficient of the second substrate are the same.

6. A package comprising:
a semiconductor sensor device according to any one of claims 1 to 5 that includes a semiconductor chip; and
a package housing to which the semiconductor chip is bonded.

7. A module comprising:
a semiconductor sensor device according to any one of claims 1 to 5 that includes a semiconductor chip; and
a module substrate to which the semiconductor chip is bonded.

8. An electronic device comprising:
a semiconductor sensor device according to any one of claims 1 to 5.

9. An electronic device comprising:
a package according to claim 6.

10. An electronic device comprising:
a module according to claim 7.

11. A method of manufacturing a semiconductor sensor device, comprising:
preparing a semiconductor sensor chip that includes a first substrate, a sensor circuit formed on the first substrate, a first conductive portion electrically connected to the sensor circuit, and a first redistribution layer electrically connected to the first conductive portion;
preparing a semiconductor chip that includes a second substrate, a processing circuit, formed on the second substrate, that processes an electrical signal output from the sensor circuit, a second conductive portion electrically connected to the processing circuit, and a second redistribution layer electrically connected to the second conductive portion;
forming a first protective layer so as to cover the first redistribution layer, and forming a first exposed portion by removing a portion of the first protective layer so that the first redistribution layer is exposed;
forming a conductive connection component on the first exposed portion; forming a second protective layer so as to cover the second redistribution layer, and forming a second exposed portion by removing a portion of the second protective layer so that the second redistribution layer is exposed; and
electrically connecting the conductive connection component and the second exposed portion.

12. A method of manufacturing a package using the method of manufacturing a semiconductor sensor device according to claim 11, comprising:
bonding the semiconductor chip in a package housing; and electrically connecting a conductive portion which is not connected to the second exposed portion and the package housing.

13. A method of manufacturing a module using the method of manufacturing a semiconductor sensor device according to claim 11, comprising:
bonding the semiconductor chip to a module substrate; and
electrically connecting a conductive portion which is not connected to the second exposed portion and the module substrate.
